# EUROPEAN PATENT SPECIFICATION

(11) **EP 0 503 211 B1**
(45) Date of publication and mention of the grant of the patent: **01.06.1994**
(21) Application number: 91810161.9
(22) Date of filing: 11.03.1991
(51) Int. Cl.: H01S 3/19, H01L 33/00, H01L 21/20, H01L 29/73

(54) **Semiconductor device comprising a layered structure grown on a structured substrate**
Halbleiteranordnung mit einer auf einem strukturierten Substrat aufgewachsenen Schichtstruktur
Dispositif semi-conducteur comprenant une structure en couches fabriquée par croissance sur un substrat structuré

(43) Date of publication of application: 16.09.1992
(73) Proprietor: INTERNATIONAL BUSINESS MACHINES CORPORATION, Armonk, NY 10504 (US)
(72) Inventor: Roentgen, Peter, Dr., CH-8800 Thalwil (CH); Heuberger, Wilhelm, CH-8805 Richterswil (CH); Unger, Peter, Dr., CH-8800 Talwil (CH); Bona, Gian-Luca, CH-8910 Affoltern am Albis (CH)
(74) Representative: Barth, Carl Otto

(56) References cited:
- ELECTRONICS LETTERS, vol. 25, no. 12, 8th June 1989, pages 758-759; S. MINAGAWA et al.: "Dependence of photoluminescence peak energy of MOVPE-grown AlGaInP on substrate orientation"
- JAPANESE JOURNAL OF APPLIED PHYSICS, vol. 29, no. 9, part 2, September 1990, pages L1666 - L1668; Y. UENO et al.: "Novel window-structure AlGaInP visible-light laser diodes with non-absorbing facets fabricated by utilizing GaInP natural superlattice disordering"
- APPLIED PHYSICS LETTERS, vol. 55, no. 1, 3rd July 1989, pages 53-55; M.E. HOENK et al.: "Compositional modulation in AlxGa1-xAs epilayers grown by molecular beam epitaxy on the (111) facets of grooves in a nonplanar substrate"
- APPLIED PHYSICS LETTERS, vol. 50, no. 11, 16th March 1987, pages 673-675; A. GOMYO et al.: "Evidence for the existence of an ordered state in Ga0.5In0.5P grown by metalorganic vapor phase epitaxy and its relation to band-gap energy"

## Description

### TECHNICAL FIELD

The invention concerns semiconductor devices such as laser diodes comprising layered structures grown on a structured substrate having horizontal surface regions with adjacent inclined sidewall facets. The invention is particularly well suited for visible wavelength laser diodes with an active layer consisting of a compound semiconductor (III/V or other). The active layer can be "terminated" in any lateral direction with wider bandgap material whereby buried devices providing for strong confinement and non-absorbing mirror structures can be obtained.

### BACKGROUND OF THE INVENTION

One of the major applications of the present invention is in the field of semiconductor laser diodes which are now being used in a wide variety of information handling systems because of their compact size and because their technology is compatible with that of associated electronic circuitry. These lasers are being used in areas such as data communication, optical storage and laser beam printing and have been optimized for the particular applications with regard to their wavelength, optical power, their high speed modulation capabilities, beam quality, etc.

The invention herein described, though applicable to a rather broad spectrum of different devices, is of particular interest for short wavelength lasers employed e.g. in laser printers and optical disk systems requiring narrow beams at high optical power. Very attractive for such applications are (Al)GaInP laser diodes operating in the 0.6µm wavelength range. These short wavelength materials, however, have characteristics that are different from those of the widely investigated and used (Al)GaAs material systems and that lead to additional problems. In other words, concepts and designs adequate for (Al)GaAs devices are not generally suitable for visible light lasers.

The present invention provide for solutions to two of the key requirements, namely
- strong current and carrier confinement to obtain low threshold, highly efficient laser diodes, and
- protection against catastrophic optical mirror damage (COMD) occuring due to heat developing at the mirror facets, to permit high output power operation for long device lifetimes.

Substantial improvements with regard to carrier and current confinement have already been achieved with so-called buried structures wherein the active layer of the laser is embedded in wider bandgap material in the direction parallel to the waveguide forming the laser cavity. However, known structures require rather complex fabrication processes. Most commonly used is a process starting with an etch step to obtain a mesa including the GaInP active layer. The mesa is then buried using a sequence of epitaxial regrowth steps. This technology is not only accompanied by a strong loss in device yield, but moereover can also cause severe device reliability problems.

Another example of a buried structure and its fabrication process have been disclosed in the published European Patent Application 0 348 540 "Process for the selective Growth of GaAs". Here, a patterned substrate, with horizontal and inclined surface sections of different crystal orientation, is used to provide for selective growth of the active layer on horizontal surfaces whereas the embedding wider bandgap cladding layers grow on both, the horizontal and the inclined surfaces. Like other methods that rely on crystal orientation dependent no- or reduced-growth effects, this process is problematic in that, during the epitaxy process, no- or reduced-growth unprotected facets may be contaminated, the crystal structure affected.

Great efforts have also been invested in the design of laser structures having non-absorbing mirrors (NAM) to avoid excessive heating due to non-radiative carrier recombination near the mirror facets. Here, the general approach is to terminate the active layer with a so-called window structure consisting of transparent, wider bandgap material thereby substantially reducing the number of carrier pairs near the facet. Such NAM laser structures have been disclosed in the following documents :
- Article "Non-Absorbing Laser Mirrors", published in IBM's Technical Disclosure Bulletin, Vol. 31, No.2, July 1988, p. 240. Described is an (Al)GaAs laser consisting of a layered structure comprising an active GaAs quantum well layer embedded between cladding layers. The layers are grown on the structured surface of a GaAs substrate : the center portion on a (100)-plane, both mirror regions on (411)-planes. Since the GaAs growth speed is remarkably lower on the (411)-surfaces, the width of the active quantum well layer is reduced near the mirror regions. This results in an increase in effective bandgap.
- European Patent Application 0 332 723 "High-Power Semiconductor Diode Laser" shows a laser structure formed on a patterned substrate having planar mesa- and groove-sections with inclined transition zones inbetween. The layered structure comprises an active and a passive waveguide, the gain segment of the active waveguide being aligned with the non-absorbing section of the passive waveguide. Light generated in the gain section is coupled through an inclined cladding layer into the non-absorbing section where it is fully guided when propagating towards the mirror facets.
- Article "Vertically Emitting Laser with integrated NAM deflector", published in IBM's Technical Disclosure Bulletin, Vol.32, No.3B, August 1989, pp.498/499, proposes other forms of non-absorbing mirror or defector structures. In one instance, the active layer, made of quantum wells, is disordered by ion implantation or diffusion. This local disordering rises the bandgap of the active layer. In another embodiment, the active layer is bent just before the deflector. The light beam impinges on the deflector in its non-absorbing part formed by a wider bandgap cladding layer.
- Article "Novel Window-Structure AlGaInP visible LDs with non-absorbing Facets formed by disordering of natural Superlattice in GaInP Active Layer", by Y.Ueno et al, published in Conference Digest 12th IEEE International Semiconductor Laser Conference, Davos/Switzerland, September 1990, pp.30/31. A visible light AlGaInP laser diode is described that has a higher bandgap (E_{g}) crystal incorporated at the mirror facets. This is accomplished by selective disordering the GaInP active layer with diffused impurity (Zn) near the facets whereby E_{g} is increased. A marked increase in maximum light output power is demonstrated.
- Article "Window-Structure InGaAlP Visible Light Laser Diodes by Self-Selective Diffusion-Induced Disordering" by K. Itaya et al, published in the same Conference Digest as the previous reference (on pages 36 / 37). Again, Zn-diffusion-induced disordering is used to create a wider bandgap window region for an InGaAlP laser structure. The diffusion is obtained below an n-cap layer selectively left in the mirror region.

These known NAM concepts require rather complex structures and fabrication processes and there is a demand for higher yield, "easy-to-make" NAM laser diodes.

The invention hereinafter described allows the design of laser devices where strong current and carrier confinement as well as NAM waveguides can be realized within a single epitaxial step. This is achieved through local bandgap variation by simultaneous in-situ growth of group III ordered phase and disordered phase semiconductor material on a structured substrate.

The invention is based on the phenomenon that some semiconductor materials, especially (Al)GaInP which becomes very important for visible light laser applications, have been found
- to exist in several phases, i.e., ordered and disordered, which differ in the atomic arrangement of group III species,
- to have a bandgap energy E_{g} that increases when changing from the ordered to the disordered phase, and
- to grow under standard Metal Organic Vapor Phase Epitaxy (MOVPE) growth conditions in the ordered phase on a standard substrate orientation (or on a slightly misoriented surface) whereas, in case of stronger misoriented substrates, the disordered phase is obtained.

These material characteristics have been investigated and reported on in the following articles :
- "Evidence for the Existence of an ordered State in GaInP grown by Metal Organic Vapor Phase Epitaxy and its Relation to Band-Gap Energy", by A.Gomyo et al, published in Appl.Phys.Lett. 50(11), 16 March 1987, pp.673-675. It is demonstrated that MOVPE epitaxial layers can, depending on III/V ratios and growth temperatures, assume states of different bandgap energy (E_{g}) corresponding to an ordered and to a random (Ga,In) distribution on column III sublattices.
- "Dependence of Photoluminescence Peak Energy of MOVPE-grown AlGaInP on Substrate Orientation", by S.Minagawa et al, published in Electronic Letters, 8th June 1989, Vol.25, No.12, pp.758/759. This is a report on measurements of GaInP and AlGaInP materials grown by MOVPE. It has been found that the bandgap increases as the substrate misorientation with respect to the (100)-plane increases and that it saturates at high inclination angles due to complete transformation into random alloy.

These articles describe the material properties on which the present invention is based but do neither suggest the use of structured substrates to selectively obtain regions of different bandgap, nor do they propose the application of the investigated phenomena to achieve buried heterostructures and/or non-absorbing mirror facets in diode laser technology.

Applied Physics Letters, Vol.55, No. 1, July 1989, Pages 53-55, discloses a lateral junction defined by compositionally modulated growth of AlGaAs epilayers on (111) facets of grooves in a nonplanar substrate.

### SUMMARY OF THE INVENTION

A main object of the present invention is to provide a semiconductor device with improved current and carrier confinement characteristics that can be fabricated using conventional, easy-to-control processes.

Another main object is to provide a semiconductor device such as a laser diode having an active waveguide with essentially non-absorbing mirror sections that can be fabricated using a one-step epitaxy process.

A further object is to provide a semiconductor device comprising an active waveguide having sections of wide bandgap material in both lateral directions to improve carrier confinement and to obtain non-absorbing mirrors.

Still another object is to provide a semiconductor device such as a laser diode and a method for its fabrication, the device having an active layer comprising sections of different bandgap energies, wherein the active layer can be fabricated in-situ in a single process step.

The invention as defined in claims 1 and 10 is intended to meet these objectives and to remedy the deficiencies of known semiconductor devices, particularly of laser diodes. This is accomplished in that the layered structure forming the device is grown on a structured substrate. At least the active layer is of a semiconductor material that assumes ordered or disordered states as a function of the substrate surface orientation or misorientation, these states having different bandgap energies E_{g}. Inclined terminating sections of the active layer, grown on misoriented substrate surface portions, provide for a bandgap energy higher than that of the center section and thus allow the fabrication of buried lasers and/or of active layers terminated with a wide bandgap section which, in laser diode applications, provides for non-absorbing mirrors.

The active layer, comprising high and low bandgap regions, can be fabricated in-situ, i.e., in a single epitaxy process step.

The main advantages offered by the invention can be summarized as follows :
- The buried heterostructure device provides, in laser applications, for improved confinement, and/or for non-absorbing mirrors protecting the device against catastrophic optical mirror damage, and can be fabricated using non-critical conventional epitaxy processes;
- Improved laser performance with respect to threshold current values, efficiency, reliability and optical output power can be achieved;
- Planar technology processes can be employed because the relied-upon effect requires only small inclination angles at the substrate surface, and the in-situ epitaxial deposition process reduces critical alignment requirements to a minimum; and
- The use of shallow, inclined facets avoids material redistribution and differences in reaction rates that, otherwise, cause local changes in composition and result in strain or in the formation of defects.

### DESCRIPTION OF THE DRAWINGS

Different ways of implementing the invention are described in detail below with reference to drawings which illustrate specific embodiments and in which
- **Fig. 1**: shows, for two laser diodes deposited during the same growth run but on substrates of different surface misorientation, how the bandgap energy and thus the emission wavelength is affected.
- **Fig. 2A/2B**: are schematic views of layered ridge (A) and groove (B) structures that are used to illustrate the phenomenon on which the invention is based.
- **Fig. 3**: is a perspective view of a first embodiment of the invention; shown is a groove-type laser diode having a buried active layer for achieving effective confinement.
- **Fig. 4**: is a perspective view of a second embodiment of the invention; shown is a groove-type laser diode having non-absorbing mirror sections in order to avoid catastrophic optical damage.
- **Fig. 5**: is a perspective view of a third embodiment of the invention; shown is a groove-type laser diode having both, a buried active layer and non-absorbing mirror sections, thereby providing for effective confinement and for high power output by avoiding catastrophic optical damage caused by heat developing at the mirrors.

### DETAILED DESCRIPTION

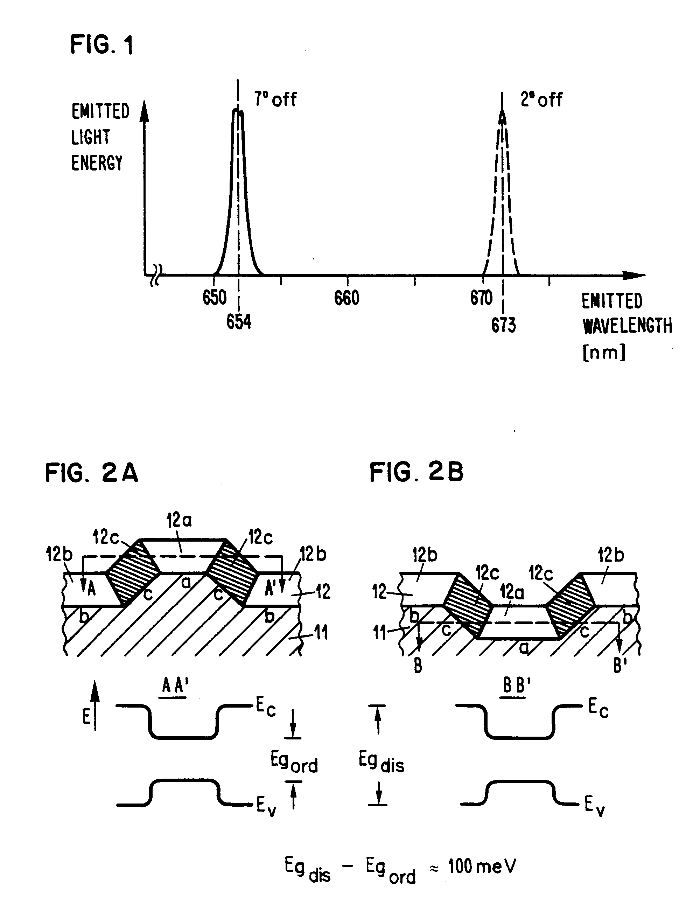

Before describing the embodiments of the inventive semiconductor device in greater detail, the basic principles on which the invention is based will be outlined with the aid of Fig. 1 and 2A / 2B.

Some III/V compound semiconductor materials, especially (Al)GaInP, can exist in different phases which differ in the atomic arrangement of group III species. Depending on the conditions during growth, e.g. in a Metal Organic Vapor Phase Epitaxy (MOVPE) process, a random or disordered alloy phase, or an ordered phase, where Ga and In atoms are regularly arranged, e.g. in the <111> direction, is obtained. The most interesting difference between the two phases is that the bandgap energy E_{g} of the same material is, in the disordered phase, 70 to 150 meV higher than in the ordered phase. Whether the semiconductor material will grow in the ordered or in the disordered phase, can be determined by the orientation of the substrate on which it is grown. Under typical MOVPE growth conditions, yielding high optical quality materials, GaInP grows in the ordered phase on standard substrate orientations like (100) or slightly off-orientations (e.g. 2°), whereas it will grow in the disordered, random alloy phase on a stronger misoriented substrate, a rather low off-angle of e.g. 7° already being sufficient.

Fig.1 shows emission spectra of two lasers (of the GaInP MQW GRINSCH type) grown simultaneously side by side on (100) 2° off = > (110) and 7° off = > <111>A GaAs substrates, respectively. The emission wavelengths of the two lasers have been measured as 673 nm and 654 nm for the 2 ° off and the 7° off substrate orientations, respectively, the difference in wavelength being caused by the difference in bandgap energy. The composition of the alloys deposited on the two substrates has been measured and determined to vary by less than 1 %, thus verifying that stoichiometric incorporation is obtained despite the small inclination difference.

It has now been found that local bandgap variations can also be obtained within a layer or layered structure that is grown on a single structured substrate having surface regions of different misorientation.

This is illustrated in Fig.2A showing schematically a simple structure comprising a structured substrate onto which an (Al)GaInP-layer is grown. The substrate, designated 11, may consist of (100)-oriented GaAs. As shown, it is structured to form a shallow ridge providing horizontal mesa (a) and groove (b) regions that are (100)-oriented or only slightly misoriented, as well as inclined transition regions (c) of stronger misorientation. Grown on this structured surface is a layer 12 of (Al)GaInP, i.e., a III/V compound semiconductor material that can exist in either the ordered or in the disordered phase. On the oriented (or slightly misoriented) horizontal surface regions (a,b), the (Al)GaInP layer is in its ordered phase with a bandgap corresponding to an emission wavelength of about 670 nm whereas, in the inclined regions (c) of stronger misorientation, the material is disordered, the bandgap corresponding to an emission wavelength of about 650 nm. This is illustrated in the figure: sections 12a and 12b of (Al)GaInP layer 12, grown on oriented substrate surfaces a and b, consist of ordered material whereas sections 12c (shaded areas), grown on misoriented substrate surfaces c, are of the disordered type.

The changes in bandgap energy E_{g} that occur at the ordered-disordered material interfaces are schematically illustrated in the energy (E) diagrams of the conduction band (E_{c}) and the valence band (Eᵥ) shown below the structure. The difference between the energy gaps Eg_{dis} (for the disordered material) and Eg_{ord} (for the ordered material), has been found to be in the range 70 to 150 meV.

Fig.2B is an illustration of a groove-structure showing the same effect : layer 12, grown on the structured surface of substrate 11, comprises ordered and disordered regions as in the ridge structure of Fig.2A, resulting in the same energy diagram.

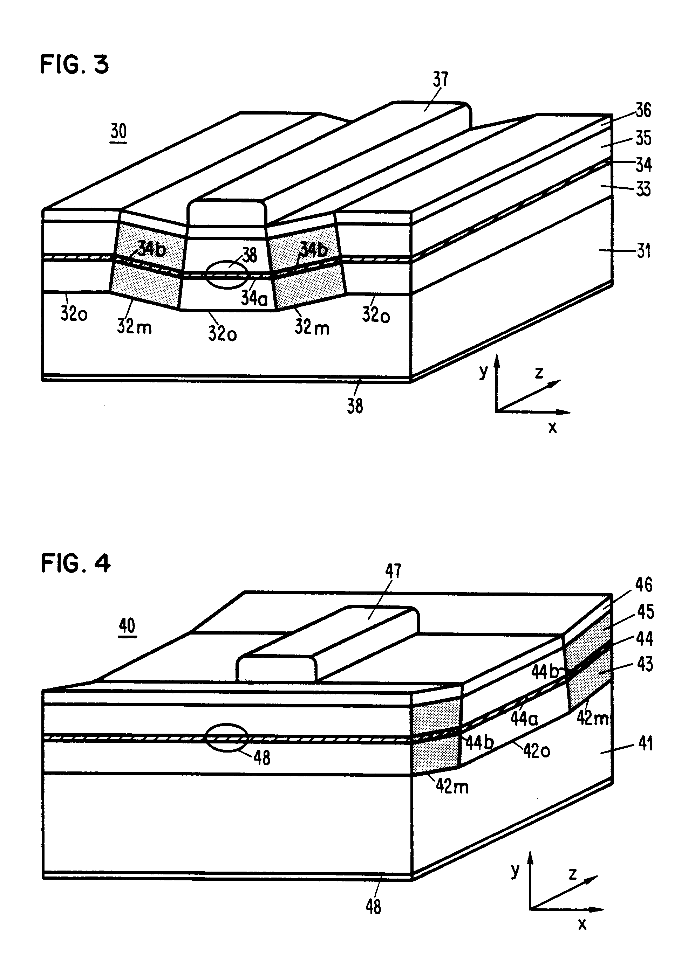

Fig.3 is a perspective view of a first embodiment of a semiconductor device designed and fabricated in accordance with the present invention, the embodiment being a laser diode structure 30 providing for improved lateral current and carrier confinement.

Basically, laser 30 is a groove-type structure grown on an n-doped GaAs substrate 31 having a structured surface. The substrate surface comprises horizontal regions 32o with inclined transition regions or sidewall facets 32m inbetween. The shallow groove formed at the substrate surface is in the direction of the light emitting waveguide of the laser structure (in Fig.3 parallel to the z-coordinate). Grown on the structured surface is a stack of semiconductor layers. In the embodiment, this consists of an n-doped AlGaInP lower cladding layer 33, the active, undoped GaInP layer 34 for carrier recombination and light guiding, a p-doped AlGaInP upper cladding layer 35, and a highly doped, low resistance p-GaAs contact layer 36. Ohmic contacts 37 and 38 are arranged as shown on top of the contact layer 36 and at the bottom of the substrate 31, respectively. At both ends of the layered structure, mirror facets (in x-y planes) are formed, their distance determining the length of the laser cavity.

When applying a voltage of sufficient level and proper polarity to the ohmic contacts to feed a current through the device that exceeds the threshold current, a laser beam parallel to the plane of the active layer 34 is emitted from light mode region 38.

In accordance with the invention, the horizontal surface regions 32o are "oriented", the orientation being determined by the substrate used, in the example a standard (100)-oriented GaAs substrate. In contrast thereto, the inclined regions 32m are misoriented, the inclination angle being 7°. Due to the above explained phenomena, causing certain materials to grow in the disordered phase on misoriented surfaces, the (Al)GaInP sections over the inclined sidewall facets 32m (in the figure shown as shaded areas) are of a material having a higher bandgap than that of the sections grown over oriented substrate surface regions 32o.

As a result, section 34a of the active layer, in which the recombination proceeds and the laser beam is generated, is laterally buried by terminating sections 34b of higher bandgap material that provide for excellent current and carrier confinement. The bend in the layer provides, in addition, for good lateral optical confinement. If desired, stronger confinement can be achieved by stronger bending of the active layer.

Now, the fabrication process for the laser structure 30 of Fig.3 will be outlined.

Starting point is a standard (100)-oriented n-doped GaAs substrate having an Si doping concentration of 2 × 10¹⁸cm⁻³. Next, the shallow grooves are prepared on the substrate surface using standard lithography and etching techniques. First, photoresist stripes parallel to the z-axis are formed to define the groove, the groove then being formed in a wet chemical etch process, using e.g., a mixture of H₂SO₄, H₂O₂, and water. Underetching causes the formation of the desired inclined sidewall facets. In the embodiment, the groove of the structured surface is about 0.5 µm deep and at the bottom (horizontal region 32o) 6µm wide; regions 32m are about 4 µm long, the inclination about 7°.

After removal of the photo resist stripes, the substrate is loaded into an MOVPE system where the following layers are epitaxially grown in a single in-situ process :
- n-doped lower cladding layer 33 of (AlₓGa₍₁₋ₓ₎)_{0.5}In_{0.5}P with an Al-concentration x = 0.8, 1 µm thick and with an Si-doping of 1 × 10¹⁸cm⁻³
- undoped active layer 34 of Ga_{0.5}In_{0.5}P, approx. 100 nm thick;
- p-doped upper cladding layer 35 of (AlₓGa₍₁₋ₓ₎)_{0.5}In_{0.5}P with an Al-concentration x = 0.8, 1 µm thick and with an Zn-doping of 1 × 10¹⁸cm⁻³ and
- p-doped contact layer 36 of GaAs, 200 nm thick and with a Zn-doping of 1 × 10¹⁹cm⁻³.

In a next step, ohmic contact stripes 37 are applied on top of the GaAs contact layer 36. The stripe geometry of the contact is determined and formed using a lithographically patterned photoresist mask for the evaporation of the contact metal which may consist of a titanium/platinum/gold sandwich, this being followed by a lift-off process. Ohmic contact 38 at the bottom side of the n-doped substrate 31 is obtained by alloying germanium, gold and nickel. Finally, the substrate is cleaved to form the mirror facets and to separate the devices.

Fig.4 is a perspective view of a second embodimemt of the invention. Shown is a laser diode 40 with non-absorbing mirror (NAM)sections allowing for high-power operation. A very simple gain-guided laser structure is chosen since it appears to be best suited for the explanation of the present invention.

Basically, laser 40 is of a structure similar to that of Fig.3, the main difference being that the groove is formed in the x-direction, i.e., it is perpendicular to the emitting waveguide of the device.

Laser 40 is grown on an n-doped GaAs substrate 41 having a structured surface with horizontal region 42o and, at both ends thereof, inclined terminating regions 42m. The shallow groove so formed is perpendicular to the waveguide of the laser structure. Grown on the substrate is a stack of semiconductor layers, comprising an n-doped AlGaInP lower cladding layer 43, undoped GaInP active layer 44, upper p-doped AlGaInP cladding layer 45, and a p-doped contact layer 46. Ohmic contacts 47 and 48 are applied as shown on the top of the contact layer 46 and to the bottom of the substrate 41. Mirror facets, in x-y planes, are formed at both ends of the layered structure.

In accordance with the invention, the horizontal surface region 42o is "oriented", e.g. (100), whereas the inclined regions 42m are misoriented, e.g., 7° off. As a result, the sections of the semiconductor layers grown onto the oriented substrate substrate region 42o are in the ordered phase, whereas the sections above the misoriented, inclined surfaces 42m are in the disordered phase. Since the (Al)GaInP semiconductor material grows in the disordered, higher bandgap phase on misoriented surfaces, the semiconductor sections over the inclined sidewall facets 42m (in Fig 4 shown as shaded) consist of material having a higher bandgap energy than the sections grown over oriented substrate surface 42o.

As a result, gain section 44a of the active layer in which the laser beam is generated, is terminated at both mirror ends with higher bandgap sections 44b providing a window or NAM portion through which the laser light is emitted. Due to the high bandgap termination of the active layer, the number of carrier pairs in the mirror section is greatly reduced whereby non-radiative carrier recombination and the resulting heat development are avoided. The light beam "follows" the bended active layer, leaving the device at light mode region 48.

The process employed to fabricate the laser of Fig.3, can be used substantially unchanged and with the same materials, dimensions, doping concentration, etc., for the fabrication of the device shown in Fig.4. Of course, the groove dimensions and its orientation with respect to the active waveguide need to be adjusted. The inclination angle and the length of the inclined, misoriented surface regions may be kept the same but the width of the groove has to be increased (to e.g. 250 to 300µm) and adjusted to obtain the desired cavity length of the laser.

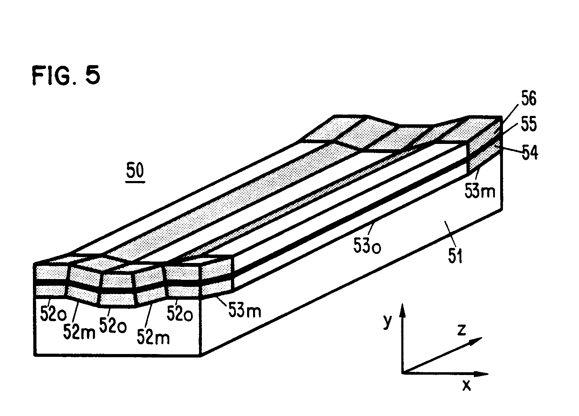

Fig.5 shows a simplified schematic view of a third embodiment of the invention. It illustrates a laser diode 50 having higher bandgap sections terminating the active layer in both lateral directions whereby devices with good confinement AND with non-absorbing mirrors, providing for high output power, can be obtained.

Basically, the laser 50 consists, like the devices illustrated in Fig.3 and 4, of a stack of layers grown on the structured surface of a substrate 51. The stack includes a lower cladding layer 54, an active layer 55, and an upper cladding layer 56. For simplicity reasons, the contact layer, deposited on top of cladding layer 56, and the ohmic contacts attached to the contact layer and to the substrate are not shown.

The structure differs from those of Fig.3 and 4 in that the substrate surface and thus the epitaxially grown semiconductor layers form grooves not only in one direction (z or x) as in the previously described embodiments but in two directions : parallel to the active waveguide in the z-direction and, perpendicular thereto, in the x-direction.

This is accomplished by more complex structuring of the substrate surface. In the z-direction, the surface has horizontal, oriented surface regions 52o with inclined, misoriented regions 52m inbetween, whereas, in the x-direction, the surface has horizontal regions 53o, oriented where "in line" with the horizontal regions 52o, and inclined and misoriented regions 53m. In Fig.5, those sections of the different semiconductor layers that are grown on inclined substrate surfaces and thus of higher bandgap energy are emphasised, appearing as shaded areas.

The completed device 50 of Fig.5, when fabricated in accordance with the processes described above in connection with the first two embodiments, combines the features and effects achieved with the earlier desribed devices in that it provides for strong carrier confinement and for a NAM structure.

With reference to the embodiments herein described, it has been shown that by choosing a suitable arrangement of the grooves and the mirror facets, lasers with lateral current confinement as well as lasers with non-absorbing mirrors, and even a combination of both, can be achieved.

The disclosed embodiments are groove-type devices but it should be noted that the same results can be obtained using other devices such as ridge-type devices when their design is based on the same concept and fabricated using the processes herein described essentially unmodified.

The invention is not only applicable to laser diodes. It will also lead to improvements in other semiconductor devices where the structure provides for bandgap-controlled carrier confinement. The invention could be of particular interest for bipolar devices.

In general, the invention is by no means limited to devices and processes using the particular materials, dimensions, doping concentration or process parameters used for the above described embodiments. To name just a few deviations or alternatives :
- The invention may be applied in compound systems other than (AI)GaInP. III/V or II/VI compounds, ternary, quaternary, etc., are candidates provided the material can exist in two distinct phases, which differ in the atomic arrangement and in band energy.
- In the described embodiments, the substrates used were of a standard orientation such as (100), allowing normal epitaxial growth. Substrates of different orientation may also be used provided they allow proper growth with the employed epitaxy process.
- Instead of using an "exactly oriented" substrate such as (100), a slightly "off" oriented substrate surface may also be used. This can be advantageous in that it provides for defined nucleus serving as basis for crystal growth. High quality devices can be grown on slightly misoriented, e.g., 2° off, surfaces. Different misorientation directions are feasible, directions (110) and (111) being examples.
- The required misoriented substrate surfaces on which disordered material is to grow, may be obtained with inclination angles other than the above described 7°. In fact, structures with angles of about 25° which are easier to make, have been successfully tested. For even larger angles, limitations are to be expected. They may lead to changes in material composition as described above, or may deteriorate the waveguide function. In addition, the advantageous planar technology may not be applicable anymore.
- A preferred process for fabricating the inventive device is the MOVPE, but other epitaxy processes will be suitable as well provided the atomic ordering effect on which the invention is based can be achieved.
- In fabricating the inventive structure, a cleavage process for forming the mirror facets and for separating the devices grown on the substrate can be used as indicated above. Other methods such as etch processes, particularly Reactive Ion Etch (RIE) techniques, may equally well be used to form the mirror facets.

## Claims

1. Semiconductor device (30, 40, 50) comprising a layered structure including at least one compound semiconductor layer (34, 44, 55), deposited on a structured substrate (31, 41, 51) with a surface having horizontal regions (32o, 42o, 52o) with adjacent inclined sidewall facets (32m, 42m, 52m),
whereby
- said compound semiconductor layer (34, 44, 55) consists of a material that, depending on the orientation or misorientation of the substrate surface on which the layer is deposited, assumes either an ordered or a disordered state, these states exhibiting different bandgap energies,
- said compound semiconductor layer (34, 44, 55) comprises a center section (34a, 44a) deposited over a horizontal region (32o, 42o, 52o) of said structured substrate, and terminating sections (34b, 44b) deposited over said inclined sidewall facets (32m, 42m, 52m) and extending from the center portion (34a, 44a) in at least one lateral direction,
and in that
- the orientation or misorientation of said sidewall facets (32m, 42m, 52m) is such that said terminating sections (34b, 44b) have a bandgap energy larger than that of said center portion (34a, 44a).

2. Semiconductor device as in claim 1, wherein the device is a laser diode and the compound semiconductor layer is the active layer of the diode laser.

3. Semiconductor device as in claim 2, wherein the active layer (34), comprising said center section (34a) and said terminating sections (34b), is sandwiched between cladding layers (33, 35) to form an active waveguide, the terminating sections (34b) being parallel to the longitudinal axis of the waveguide, thus providing for lateral confinement.

4. Semiconductor device as in claim 2, wherein the active layer (44), comprising said center section (44a) and said terminating sections (44b), is sandwiched between cladding layers (43, 45) to form an active waveguide, the terminating sections (44b) being perpendicular to the horizontal axis of said waveguide, thus providing for a non-absorbing mirror structure.

5. Semiconductor device as in claim 2, wherein the active layer (55), comprising said center section and said terminating sections, is sandwiched between cladding layers (54, 56) to form an active waveguide, terminating sections being arranged parallel as well as perpendicular to the horizontal axis of said waveguide, thus providing for both, lateral confinement and non-absorbing mirror termination.

6. Semiconductor device as in claim 1, wherein the device consists of (Al)GaInP-system semiconductor material.

7. Semiconductor device as in claim 1, wherein the device is a bipolar device of a structure providing for bandgap-controlled carrier confinement.

8. Semiconductor device as in claim 1, wherein the substrate is of a standard crystal orientation such as (100), either exact or about 2° misoriented.

9. Semiconductor device as in claim 1, wherein the inclination angle of said sidewall facets is in the range of 6 to 30°.

10. A process for fabricating a semiconductor device (30, 40, 50) comprising a layered structure including at least one compound semiconductor layer (34, 44, 45) deposited on a structured substrate (31, 41, 51) with a surface having horizontal regions (32o, 42o, 520o) with adjacent inclined sidewall facets (32m, 42m, 52m)
the process comprising the steps of
- structuring the surface of the substrate (31, 41, 51) on which the layered structure is to be grown, the surface orientation of the horizontal regions (32o, 42o, 52o) substantially corresponding to a standard crystal orientation ((100), (100) 2° off) whereas the inclined sidewall facets (32m, 42m, 52m) are misoriented with respect thereto, and
- successive deposition of the layers (33 to 36; 43 to 46; 54-56) forming said layered structure on the structured substrate surface, at least said compound semiconductor layer (34, 44, 55) consisting of a material that, depending on the orientation or misorientation of the substrate surface on which the layer is deposited, assumes either an ordered or a disordered state, these states exhibiting different bandgaps,
such that, in the layered structure, the center section (34a, 44a) of said compound semiconductor layer (34, 44, 55) is deposited over a horizontal region (32o, 42o, 52o) of said structured surface, and terminated in at least one lateral direction by terminating sections (34b, 44b) that are deposited over said sidewall facets (34m, 44m) and that have a bandgap energy larger than that of the center section (34a, 44a).

11. A process as in claim 10, wherein the layers (33 to 36; 43 to 46; 54 to 56) forming said layered structure are deposited in-situ in a single epitaxy process.

12. A process as in claim 10, wherein for the deposition of the layers forming said layered structure, a Metal Organic Vapor Phase Epitaxy (MOVPE) process is used.

## Patentansprüche

1. Eine Halbleitereinrichtung (30, 40, 50), die eine beschichtete Struktur mit mindestens einer zusammengesetzten Halbleiterschicht (34, 44, 55) umfaßt, die auf einem strukturierten Substrat (31, 41, 51) mit einer Oberfläche abgelegt ist, die horizontale Bereiche (32o, 42o, 52o) und benachbarte schräge Seitenflächen (32m, 42m, 52m) aufweist,
wobei
- die zusammengesetzte Halbleiterschicht (34, 44, 55) aus einem Material besteht, das je nach Orientierung oder Fehlorientierung der Substratoberfläche, auf der die Schicht abgelegt ist, entweder einen geordneten oder fehlgeordneten Zustand annimmt, wobei diese Zustände unterschiedliche Bandabstandsenergien aufweisen,
- die zusammengesetzte Halbleiterschicht (34, 44, 55) einen Mittelbereich (34a, 44a) umfaßt, der über einem horizontalen Bereich (32o, 42o, 52o) des strukturierten Substrats abgelegt ist, sowie Endbereiche (34b, 44b), die über den schrägen Seitenflächen (32m, 42m, 52m) abgelegt sind und vom Mittelbereich (34a, 44) in mindestens einer seitlichen Richtung abgehen,
und daß
- die Orientierung oder Fehlorientierung der Seitenflächen (32m, 42m, 52m) ist derart, daß die Endbereiche (34b, 44b) eine Bandabstandsenergie haben, die größer als die des Mittelbereichs (34a, 44a) ist.

2. Die Halbleitereinrichtung nach Anspruch 1, bei der die Einrichtung eine Laserdiode ist und die zusammengesetzte Halbleiterschicht die aktive Schicht des Diodenlasers ist.

3. Eine Halbleitereinrichtung nach Anspruch 2, wobei die aktive Schicht (34), bestehend aus dem Mittelbereich (34a) und den Endbereichen (34b), zwischen den Umhüllungsschichten (33, 35) eingebettet ist, um einen aktiven Wellenleiter zu bilden, wobei die Endbereiche (34b) parallel zur Längsachse des Wellenleiters liegen und damit für eine seitliche Begrenzung sorgen.

4. Eine Halbleitereinrichtung nach Anspruch 2, wobei die aktive Schicht (44), bestehend aus dem Mittelbereich (44a) und den Endbereichen (44b), zwischen den Umhüllungsschichten (43, 45) eingebettet ist, um einen aktiven Wellenleiter zu bilden, wobei die Endbereiche (44b) senkrecht zur horizontalen Achse des Wellenleiters liegen und damit für eine nicht-absorbierende Spiegelstruktur sorgen.

5. Eine Halbleitereinrichtung nach Anspruch 2, wobei die aktive Schicht (55), bestehend aus dem Mittelbereich und den Endbereichen, zwischen den Umhüllungsschichten (54, 56) eingebettet ist, um einen aktiven Wellenleiter zu bilden, wobei die Endbereiche parallel sowie senkrecht zur horizontalen Achse des Wellenleiters liegen und damit sowohl für eine seitliche Begrenzung als auch für ein nicht-absorbierendes Spiegelende sorgen.

6. Eine Halbleitereinrichtung nach Anspruch 1, bei der die Einrichtung aus einem Halbleitermaterial des (Al)GaInP-Systems besteht.

7. Eine Halbleitereinrichtung nach Anspruch 1, bei der es sich um eine bipolare Einrichtung mit einer Struktur handelt, die für eine bandabstandsgesteuerte Trägerbegrenzung sorgt.

8. Eine Halbleitereinrichtung nach Anspruch 1, bei der das Substrat eine Standardkristallorientierung, z.B. (100), hat, die entweder exakt oder um 2° fehlorientiert ist.

9. Eine Halbleitereinrichtung nach Anspruch 1, bei der der Neigungswinkel der Seitenflächen zwischen 6 und 30° liegt.

10. Eine Verfahren zur Herstellung einer Halbleitereinrichtung (30, 40, 50), die eine beschichtete Struktur mit mindestens einer zusammengesetzten Halbleiterschicht (34, 44, 55) umfaßt, die auf einem strukturierten Substrat (31, 41, 51) mit einer Oberfläche abgelegt ist, die horizontale Bereiche (32o, 42o, 52o) und benachbarte schräge Seitenflächen (32m, 42m, 52m) aufweist,
wobei das Verfahren folgende Schritt umfaßt:
- die Strukturierung der Oberfläche des Substrats (31, 41, 51), auf dem die beschichtete Struktur aufwachsen soll, wobei die Oberflächenorientierung der horizontalen Bereiche (32o, 42o, 52o) im wesentlichen einer Standardkristallorientierung ((100), (100) mit 2° Verschiebung) entspricht, während die schrägen Seitenflächen (32m, 42m, 52m) im Vergleich dazu fehlorientiert sind, und
- die sukzessive Ablage der Schichten (33 bis 36; 43 bis 46; 54 - 56), die die beschichtete Struktur bilden, auf der strukturierten Substratoberfläche, wobei mindestens die zusammengesetzte Halbleiterschicht (34, 44, 55), die aus einem Material besteht, das je nach Orientierung oder Fehlorientierung der Substratoberfläche, auf der die Schicht abgelegt ist, entweder einen geordneten oder fehlgeordneten Zustand annimmt, und diese Zustände unterschiedliche Bandabstände haben, so daß der Mittelbereich (34a, 44a) der zusammengesetzten Halbleiterschicht (34, 44, 55) in der beschichteten Struktur über einem horizontalen Bereich (32o, 42o, 52o) der strukturierten Oberfläche abgelegt wird, und in mindestens einer seitlichen Richtung durch Endbereiche (34b, 44b) abgeschlossen wird, die über den Seitenflächen (34m, 44m) abgelegt werden und eine Bandabstandsenergie haben, die größer als die des Mittelbereichs (34a, 44a) ist.

11. Ein Verfahren nach Anspruch 10, bei dem die Schichten (33 bis 36; 43 bis 46; 54 bis 56), die die beschichtete Struktur bilden, in-situ in einem einzigen Epitaxieverfahren abgelegt werden.

12. Ein Verfahren nach Anspruch 10, bei dem für die Ablage der Schichten, die die beschichtete Struktur bilden, ein Metall-organisches Dampfphasenepitaxie-Verfahren (MOVPE-Verfahren) angewendet wird.

## Revendications

1. Dispositif semi-conducteur (30, 40, 50) comprenant une structure en couches comportant au moins une couche semi-conductrice composée (34, 44, 55), déposée sur un substrat structuré (31, 41, 51) avec une surface ayant des régions horizontales (32o, 42o, 52o) avec les faces des parois adjacentes inclinées (32m, 42m, 5m); dans lequel:
ladite couche semi-conductrice composée (34, 44, 55) consiste en un matériau qui, dépendant de l'orientation ou de la non orientation de la surface du substrat sur lequel la couche est déposée, assure un état ordonné ou un état non ordonné, ces états présentant des énergies d'intervalles de bandes différentes,
ladite couche semi-conductrice (34, 44, 55) comprend une section centrale 34a, 44a) déposée sur une région horizontale (32o, 42o, 52o) dudit substrat structuré, et des sections terminales (34b, 44b) déposées sur lesdites faces des parois inclinées (32m, 42m, 52m) et s'étendant de la section centrale (34a,44a) dans au moins une direction latérale, et
l'orientation ou la non orientation desdites faces des parois (32m, 42m, 52m) est telle que les sections terminales (34b, 44b) ont une bande d'énergie plus grande que celle de ladite section centrale (34a, 44a).

2. Dispositif semi-conducteur tel que dans la revendication 1, dans lequel le dispositif est une diode laser et la couche semi-conductrice composée est la couche active de la diode laser.

3. Dispositif semi-conducteur tel que dans la revendication 2, dans lequel la couche active (34) comprenant ladite section centrale (34a) et lesdites sections terminales (34b), est en sandwich entre des couches de revêtement (33, 35) pour former un guide d'onde actif, les sections terminales (34b) étant parallèles à l'axe longitudinal du guide d'onde, procurant ainsi un confinement latéral.

4. Dispositif semi-conducteur tel que dans la revendication 2, dans lequel la couche active (44) comprenant ladite section centrale (44a) et lesdites sections terminales (44b), est en sandwich entre des couches de revêtement (43, 45) pour former un guide d'onde actif, les sections terminales (44b) étant perpendiculaires à l'axe horizontal dudit guide d'onde, fournissant ainsi une structure de miroir non absorbante.

5. Dispositif semi-conducteur tel que dans la revendication 2, dans lequel la couche active (55) comprenant ladite section centrale et lesdites sections terminales, est en sandwich entre des couches de revêtement (54, 56) pour former un guide d'onde actif, les sections terminales étant disposées parallèles aussi bien que perpendiculaires à l'axe horizontal dudit guide d'onde, fournissant ainsi un confinement latéral aussi bien qu'une terminaison en miroir non absorbant.

6. Dispositif semi-conducteur tel que dans la revendication 1, dans lequel le dispositif consiste en un matériau semi-conducteur du système (Al)GaInP.

7. Dispositif semi-conducteur tel que dans la revendication 1, dans lequel le dispositif est un dispositif bipolaire d'une structure fournissant un confinement de porteurs à intervalles de bandes contrôlés.

8. Dispositif semi-conducteur tel que dans la revendication 1, dans lequel le substrat est d'une orientation cristalline standard telle que 100, soit exactement, soit avec un écart par rapport à l'orientation de 2°.

9. Dispositif semi-conducteur tel que dans la revendication 1, dans lequel l'angle d'inclinaison desdites faces des parois est compris entre 6 et 30°.

10. Procédé pour fabriquer un dispositif semi-conducteur (30, 40, 50) comprenant une structure en couches comportant au moins uns couche semi-conductrice composée (34, 44, 55) déposée sur un substrat structuré (31, 41, 51) avec une surface ayant des régions horizontales (32o, 42o, 52o) ayant les faces des parois adjacentes inclinées (32m, 42m, 52m); le procédé comprenant les étapes de:
structurer la surface du substrat (31, 41, 51) sur laquelle la structure en couches est obtenue par croissance, l'orientation de surface des régions horizontales (32o, 42o, 52o) correspondant substantiellement à une orientation cristalline standard ((100), (100), ou 2° d'écart) alors que les faces des parois inclinées (32m, 42m, 52m) ne sont pas orientées par rapport à elle,
déposer successivement les couches (33 à 36, 43 à 46, 54 à 56) formant ladite structure en couches sur la surface de substrat structuré, au moins ladite couche semiconductrice composée (34, 44, 55) consistant en un matériau qui, dépendant de l'orientation ou de la non orientation de la surface du substrat sur lequel la couche est déposée, assure un état ordonné ou un état non ordonné, ces états présentant des bandes d'énergie différentes,
de telle sorte que, dans la structure en couches, la section centrale (34a, 44a) de ladite couche semi-conductrice composée (34, 44, 55) est déposée sur une région horizontale (32o, 42o, 52o) de ladite surface de substrat structuré, et terminée dans au moins une direction latérale par des sections terminales (34b, 44b) qui sont déposées sur lesdites faces des parois (34m, 44m) et qui ont une bande d'énergie plus grande que celle de ladite section centrale (34a, 44a).

11. Procédé tel que dans la revendication 10, dans lequel les couches (33 à 36, 43 à 46, 54 à 56) formant ladite structure en couches sont déposées in-situ en un seul procédé épitaxial.

12. Procédé tel que dans la revendication 10, dans lequel, pour le dépôt des couches formant ladite structure en couches, un procédé épitaxial en phase vapeur organique-métal (MOVPE) est utilisé.
